(19) **Europäisches Patentamt**

**European Patent Office**

**Office européen des brevets**

(11) Veröffentlichungsnummer: **0 290 841**

**A1**

(12) # EUROPÄISCHE PATENTANMELDUNG

(21) Anmeldenummer: **88106494.3**

(51) Int. Cl.4 **C25D 11/04 , C23C 14/00**

(22) Anmeldetag: **22.04.88**

(30) Priorität: **06.05.87 DE 3715102**
**19.05.87 DE 3716767**
**28.12.87 DE 3744344**

(43) Veröffentlichungstag der Anmeldung:
**17.11.88 Patentblatt 88/46**

(84) Benannte Vertragsstaaten:
**AT BE CH DE ES FR GB GR IT LI LU NL SE**

(71) Anmelder: **Josef Gartner & Co.**
**Postfach 20/40**
**D-8883 Gundelfingen(DE)**

(72) Erfinder: **Der Erfinder hat auf seine Nennung**
**verzichtet**

(74) Vertreter: **Patentanwälte Müller-Boré, Deufel,**
**Schön, Hertel, Lewald, Otto**
**Postfach 26 02 47 Isartorplatz 6**
**D-8000 München 26(DE)**

(54) **Verfahren zur Oberflächenveredelung von Gegenständen aus Aluminium durch Eloxieren.**

(57) Bei Gegenständen aus Aluminium wird vor einer Oberflächenveredelung durch Eloxieren eine Schicht aus Aluminium mittels eines physikalischen Aufdampfverfahrens Vakuumbedampfung aufgebracht. Damit wird erreicht, daß die Eloxalschicht über die gesamte Oberfläche der Gegenstände gleichmäßig in Farbe und Stärke ausgebildet wird.

EP 0 290 841 A1

# Verfahren zur Oberflächenveredelung von Gegenständen aus Aluminium durch Eloxieren

Die Erfindung betrifft ein Verfahren zur Oberflächenveredelung von Gegenständen aus Aluminium durch Eloxieren.

Es besteht eine große Nachfrage an Gegenständen aus Aluminium, deren Oberfläche durch Eloxieren aufbereitet ist, so daß über einen langen Zeitraum die Farbechtheit der Oberfläche gewährleistet ist. Um derartige Gegenstände aus Aluminium einem nachfolgenden Eloxierverfahren zu unterziehen, muß die Qualität der Oberfläche bereits vor dem Eloxieren einem gewissen Standard entsprechen.

Der Erfindung liegt die Aufgabe zugrunde, ein Verfahren zu schaffen, mit welchem die eloxierte Oberfläche von Gegenständen aus Aluminium hohen Anforderungen entsprechend herstellbar ist.

Diese Aufgabe wird erfindungsgemäß dadurch gelöst, daß auf die Gegenstände vor dem Eloxieren Aluminium physikalisch aufgedampft wird mit einem PVD-Verfahren (physical vapor deposition) wie Aufdampfen, Kathodenzerstäuben (sputtern), Ionenplattieren (ion plating) oder Ionenimplantation.

Diese in der Technik an sich bekannten Verfahren der physikalischen Bedampfung ermöglichen es, die Aluminiumgegenstände vor dem Eloxieren mit einer dünnen, vergleichmäßigenden Schicht aus Aluminium zu versehen, so daß nach dem Eloxieren die Gegenstände an jedem Oberflächenbereich die gleiche Güte aufweisen. Bei der Herstellung der Gegenstände aus Aluminium können wirtschaftliche Verfahren verwendet werden, wie sie beispielsweise für eine Massenfertigung geeignet sind. Beispielsweise bei einem Spritzguß oder einem StrangpreßVerfahren, bei Bändern oder Blechen muß nicht notwendigerweise Wert auf eine makellose Oberfläche der Gegenstände gelegt werden, da durch nachträgliches physikalisches Aufdampfen die Schicht gleichmäßig aufgetragen wird, in der während des Eloxierens die entsprechende Reaktionen ablaufen.

Gemäß einer bevorzugten Ausführungsform wird das Aluminium in einer Schichtdicke von 10 bis 200 μm aufgedampft. Damit wird eine für das Eloxieren je nach Art des Gegenstandes ausreichend dicke Aluminiumschicht aufgedampft.

Vor dem physikalischen Aufdampfen werden die Gegenstände vorzugsweise entfettet, so daß eine gute Haftung der aufgedampften Schicht erreicht wird.

Wenn das Eloxieren nicht unmittelbar nach dem physikalischen Aufdampfen erfolgt, wird vorzugsweise nach dem Aufdampfen der Gegenstand mit einer Schutzfolie abgedeckt, so daß die Oxidbildung des Aluminiums verhindert wird. Vor dem Eloxieren wird dann die Schutzfolie von den aufgedampften Gegenständen entfernt.

## Ansprüche

1. Verfahren zur Oberflächenveredelung von Gegenständen aus Aluminium durch Eloxieren, dadurch **gekennzeichnet,** daß auf die Gegenstände vor dem Eloxieren Aluminium physikalisch aufgedampft wird mit einem PVD-Verfahren (physical vapor deposition).

2. Verfahren nach Anspruch 1, dadurch **gekennzeichnet,** daß das Aluminium in einer Schichtdicke von 10 bis 200 μm aufgedampft wird.

3. Verfahren nach Anspruch 1 oder 2, dadurch **gekennzeichnet,** daß die Gegenstände vor dem physikalischen Aufdampfen entfettet werden.

4. Verfahren nach einem der Ansprüche 1 bis 3, dadurch **gekennzeichnet,** daß eine Schutzfolie auf der aufgedampften Oberfläche aufgebracht wird.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | FR-A-2 579 999 (PRECI-COAT S.A.) <br> * Page 2, lignes 1-27; Ansprüche 1-10 * <br> --- | 1,2 | C 25 D 11/04 <br> C 23 C 14/00 |
| X | PATENT ABSTRACTS OF JAPAN, Band 8, Nr. 67 (C-216)[1504], 29. März 1984; & JP-A-58 217 697 (DAIWA SEIKOU K.K.) 17-12-1983 <br> * Zusammenfassung * <br> --- | 1,3 | |
| X | RESEARCH DISCLOSURE, Nr. 262, Februar 1986, Seite 94, Nr. 26235, Emsworth, Hampshire, GB; "Vacuum clading of aluminum castings to enhance hard anodize surface finish" <br> --- | 1 | |
| A | US-A-4 307 150 (ROCHE) <br> * Spalte 1, Zeilen 44-63 * <br> ----- | 4 | |
| | | | **RECHERCHIERTE SACHGEBIETE (Int. Cl.4)** |
| | | | C 25 D 11/04 |

Der vorliegende Recherchenbericht wurde für alle Patentansprüche erstellt

| Recherchenort | Abschlußdatum der Recherche | Prüfer |
|---|---|---|
| DEN HAAG | 26-08-1988 | VAN LEEUWEN R.H. |

EPO FORM 1503 03.82 (P0403)